# EUROPEAN PATENT APPLICATION

(11) **EP 4 770 356 A1**
(43) Date of publication of application: **01.07.2026**
(21) Application number: 25768701.2
(22) Date of filing: 04.03.2025
(51) Int. Cl.: H10H 29/14, H01L 25/075, H10D 86/40, H10H 20/857, H10H 20/841

(54) **DISPLAY MODULE AND ELECTRONIC DEVICE**

(30) Priority: 07.03.2024 KR 20240032805
(71) Applicant: Samsung Electronics Co., Ltd., Suwon-si, Gyeonggi-do 16677 (KR)
(72) Inventor: LEE, Jinwoong, Suwon-si, Gyeonggi-do 16677 (KR); YOO, Sunghyun, Suwon-si, Gyeonggi-do 16677 (KR); JEON, Jongpil, Suwon-si, Gyeonggi-do 16677 (KR); KIM, Hyunkyung, Suwon-si, Gyeonggi-do 16677 (KR); LEE, Kyehoon, Suwon-si, Gyeonggi-do 16677 (KR)
(74) Representative: Gulde & Partner
(86) International application number: PCT/KR2025/099549
(87) International publication number: WO 2025/188146

(57) **Abstract**

A display module and an electronic device are provided. The display module includes a circuit board including a plurality of individual electrodes and a plurality of common electrodes having a polarity opposite to a polarity of the plurality of individual electrodes; a plurality of light emitting diodes (LEDs), each LED of the plurality of LEDs including a plurality of semiconductor layers, a first pixel electrode connected to the plurality of individual electrodes, and a second pixel electrode at an opposite direction from the first pixel electrode, respectively; a top connection layer on the plurality of LEDs and connected to the second pixel electrode; and a plurality of connecting elements connecting the top connection layer to the plurality of common electrodes.

## Description

### [Technical Field]

The disclosure relates to a display module and an electronic device, and more specifically, to a display module in which a bonding area between an LED and a circuit board can be increased.

### [Background Art]

Recently, technology relating to compound semiconductor-based light emitting diodes (LEDs) such as GaN, GaAs, and GaP is fast-developing, and there is a growing interest for LED display devices which utilize panel configuring technology of directly mounting (transferring) LEDs that emit light of red (R), green (G), and blue (B) wavelength bands to a circuit board.

More specifically, because miniaturization of LEDs is essential for outputting high resolution images from an LED display device, many development infrastructures are being utilized for completeness of an ultra-small micro-LED of less than 100 micrometers. Further, due to a process of precisely mounting super ultra-small LEDs of tens of micrometers being developed recently, there is a need for an LED and module manufacturing technology optimized accordingly.

In general, related art with respect to micro LEDs describes electrically connecting a circuit board with LEDs using flip-chip type LEDs. However, if a flip bonding method like that of the related art is used, because two electrodes disposed at a lower portion of the LEDs are connected with an electrode of the circuit board, there may be a limit to securing a bonding area for connection between the LED and the circuit board. In addition, when two electrodes disposed at the lower portion of the LEDs are connected with the electrodes of the circuit board, there may be a limit to securing a process margin and securing mass production capability according to an increased risk of a short occurring between adjacent electrodes. Further, because limits of the related art as described above can increase as LEDs become more miniaturized, the above may still be problems that must be overcome for the miniaturization of LEDs.

### [Disclosure]

### [Technical Solution]

Provided are a display module capable of widening a bonding area between an LED and a circuit board, and an electronic device that includes the display module.

According to an aspect of the disclosure, a display module includes: a circuit board including a plurality of individual electrodes and a plurality of common electrodes having a polarity opposite to a polarity of the plurality of individual electrodes; a plurality of light emitting diodes (LEDs), each LED of the plurality of LEDs including a plurality of semiconductor layers, a first pixel electrode connected to the plurality of individual electrodes, and a second pixel electrode at an opposite direction from the first pixel electrode, respectively; a top connection layer on the plurality of LEDs and connected to the second pixel electrode; and a plurality of connecting elements connecting the top connection layer to the plurality of common electrodes.

The plurality of LEDs may include a red LED, a green LED, and a blue LED, each of the plurality of individual electrodes may be configured to drive one from among the red LED, the green LED, and the blue LED, and the plurality of common electrodes may be configured to drive the red LED, the green LED, and the blue LED.

The display module may be divided into a plurality of pixels, and each of the plurality of pixels corresponds to a connecting element of the red LED, the green LED, the blue LED, and one from among the plurality of connecting elements.

Each of the plurality of individual electrodes may be an anode, each of the plurality of common electrodes may be a cathode, each of the plurality of LEDs may include a plurality of second pixel electrodes, and the plurality of second pixel electrodes may be arranged at different regions of a light emitting surface of each of the plurality of LEDs, respectively.

The plurality of semiconductor layers may include an n-type semiconductor layer, a p-type semiconductor layer, and a light emitting layer between the n-type semiconductor layer and the p-type semiconductor layer, the p-type semiconductor layer may be connected to the first pixel electrode, the n-type semiconductor layer may be connected to the second pixel electrode, and the plurality of LEDs may further include a reflection layer surrounding the light emitting layer.

Each of the plurality of individual electrodes may be a cathode, each of the plurality of common electrodes may be an anode, the second pixel electrode of the red LED may include a metal, and the second pixel electrode of each of the green LED and the blue LED may include indium tin oxide (ITO).

The plurality of semiconductor layers may include an n-type semiconductor layer, a p-type semiconductor layer, and a light emitting layer between the n-type semiconductor layer and the p-type semiconductor layer, the p-type semiconductor layer may be connected to the second pixel electrode, the n-type semiconductor layer may be connected to the first pixel electrode, and the plurality of LEDs may further include an insulation layer surrounding the light emitting layer.

The display module may further include a bottom contact layer on the circuit board, and the bottom contact layer may include a plurality of conductive balls connecting the plurality of individual electrodes to the first pixel electrode and connecting the plurality of common electrodes to the plurality of connecting elements.

The top connection layer may be at least one of a first top connection layer which includes indium tin oxide (ITO), and a second top connection layer which includes a transparent anisotropic conductive film (ACF) and a glass substrate.

The plurality of connecting elements may include at least one of a first connecting element, a second connecting element including a metal, and a third connecting element including a metal coated polymer, and the first connecting element may include a semiconductor layer, an upper electrode at an upper portion of the semiconductor layer and connected to the top connection layer, and a lower electrode at a lower portion of the semiconductor layer and connected to a common electrode.

According to an aspect of the disclosure, an electronic device includes a display module, the display module including: a circuit board which includes a plurality of individual electrodes and a plurality of common electrodes having a polarity opposite to a polarity of the plurality of individual electrodes; a plurality of light emitting diodes (LEDs), each LED of the plurality of LEDS including a plurality of semiconductor layers, a first pixel electrode connected to the plurality of individual electrodes, and a second pixel electrode at an opposite direction from the first pixel electrode, respectively; a top connection layer on the plurality of LEDs and connected to the second pixel electrode; and a plurality of connecting elements connecting the top connection layer to the common electrode.

The plurality of LEDs may include a red LED, a green LED, and a blue LED, each of the plurality of individual electrodes may be configured to drive one from among the red LED, the green LED, and the blue LED, and the plurality of common electrodes may be configured to drive the red LED, the green LED, and the blue LED. The display module may be divided into a plurality of pixels, and each of the plurality of pixels corresponds to a connecting element of the red LED, the green LED, the blue LED, and one from among the plurality of connecting elements.

Each of the plurality of individual electrodes may be an anode, each of the plurality of common electrodes may be a cathode, each of the plurality of LEDs may include a plurality of second pixel electrodes, and the plurality of second pixel electrodes may be arranged at different regions of a light emitting surface of each of the plurality of LEDs, respectively.

The plurality of semiconductor layers may include an n-type semiconductor layer, a p-type semiconductor layer, and a light emitting layer between the n-type semiconductor layer and the p-type semiconductor layer, the p-type semiconductor layer may be connected to the first pixel electrode, the n-type semiconductor layer may be connected to the second pixel electrode, and the plurality of LEDs may further include a reflection layer surrounding the light emitting layer.

The plurality of individual electrodes may be a cathode, the plurality of common electrodes may be an anode, the second pixel electrode included in the red LED may be a metal, and the second pixel electrode included in the green LED and the blue LED may be indium tin oxide (ITO).

The plurality of semiconductor layers may include an n-type semiconductor layer, a p-type semiconductor layer, and a light emitting layer between the n-type semiconductor layer and the p-type semiconductor layer, the p-type semiconductor layer may be connected with the second pixel electrode, the n-type semiconductor layer may be connected with the first pixel electrode, and the plurality of LEDs may further include an insulation layer arranged in a surrounding of the light emitting layer.

The display module may further include a bottom contact layer arranged on the circuit board, and the bottom contact layer may include a plurality of conductive balls connecting the plurality of individual electrodes to the first pixel electrode and connecting the plurality of common electrodes to the plurality of connecting elements.

The top connection layer may be at least one from among a first top connection layer which includes ITO and a second top connection layer which includes a transparent anisotropic conductive film (ACF) and a glass substrate.

The plurality of connecting elements may include at least one from among a first connecting element including a semiconductor layer, an upper electrode arranged at an upper portion of the semiconductor layer and connected to the top connection layer, and a lower electrode arranged at a lower portion of the semiconductor layer and connected to the common electrode, a second connecting element including a metal, and a third connecting element including a metal coated polymer.

### [Description of Drawings]

The above and other aspects, features, and advantages of certain embodiments of the present disclosure will be more apparent from the following description taken in conjunction with the accompanying drawings, in which:
FIG. 1 is a diagram illustrating a portion of a display module according to one or more embodiments of the disclosure;
FIG. 2 is a diagram illustrating an enlarged portion of the display module shown in FIG. 1;
FIG. 3 is a diagram illustrating a portion of a display module according to one or more embodiments of the disclosure;
FIG. 4 is a diagram illustrating an enlarged portion of the display module shown in FIG. 3;
FIG. 5 is a diagram illustrating one or more embodiments associated with a bottom contact layer according to one or more embodiments of the disclosure;
FIG. 6 is a diagram illustrating one or more embodiments associated with a top connection layer according to one or more embodiments of the disclosure;
FIG. 7 is a diagram illustrating one or more embodiments associated with a connecting element according to one or more embodiments of the disclosure;
FIG. 8 is a diagram illustrating one or more embodiments associated with a number and position of the connecting element according to one or more embodiments of the disclosure; and
FIG. 9 is a diagram illustrating an electronic device which includes the display module according to one or more embodiments of the disclosure.

### [Mode for Invention]

Various modifications may be made to the embodiments herein, and there may be various types of embodiments. Accordingly, specific embodiments will be illustrated in drawings, and described in detail in the detailed description. However, it should be noted that the various embodiments are not for limiting the scope of the disclosure to a specific embodiment, but they should be interpreted to include all modifications, equivalents or alternatives of the embodiments included in the ideas and the technical scopes disclosed herein. With respect to the description of the drawings, like reference numerals may be used to indicate like elements.

In describing the disclosure, in case it is determined that the detailed description of related known technologies or configurations may unnecessarily confuse the gist of the disclosure, the detailed description thereof will be omitted.

Further, the embodiments below may be modified to various different forms, and it is to be understood that the scope of the technical spirit of the disclosure is not limited to the embodiments below. Rather, the embodiments are provided so that the disclosure will be thorough and complete, and to fully convey the technical spirit of the disclosure to those skilled in the art.

Terms used herein have merely been used to describe a specific embodiment, and is not intended to limit the scope. A singular expression includes a plural expression, unless otherwise specified.

In the disclosure, expressions such as "have", "may have", "include", and "may include" are used to designate a presence of a corresponding characteristic (e.g., elements such as numerical value, function, operation, or component), and not to preclude a presence or a possibility of additional characteristics.

In the disclosure, expressions such as "A or B", "at least one of A and/or B", or "one or more of A and/or B" may include all possible combinations of the items listed together. For example, "A or B", "at least one of A and B", or "at least one of A or B" may refer to all cases including (1) only A, (2) only B, or (3) both A and B.

Expressions such as "1st", "2nd", "first", or "second" used in the disclosure may limit various elements regardless of order and/or importance, and may be used merely to distinguish one element from another element and not limit the relevant element.

When a certain element (e.g., a first element) is indicated as being "(operatively or communicatively) coupled with/to" or "connected to" another element (e.g., a second element), it may be understood as the certain element being directly coupled with/to the another element or as being coupled through other element (e.g., a third element).

Conversely, when the certain element (e.g., first element) is indicated as "directly coupled with/to" or "directly connected to" the another element (e.g., second element), it may be understood as the other element (e.g., third element) not being present between the certain element and the another element.

The expression "configured to... (or set up to)" used in the disclosure may be used interchangeably with, for example, "suitable for...," "having the capacity to...," "designed to...," "adapted to...," "made to...," or "capable of..." based on circumstance. The term "configured to... (or set up to)" may not necessarily mean "specifically designed to" in terms of hardware.

Rather, in a certain circumstance, the expression "a device configured to..." may mean something that the device "may perform..." together with another device or components. For example, a phrase "a processor configured to (or set up to) perform A, B, or C" may mean a dedicated processor for performing a relevant operation (e.g., an embedded processor), or a generic-purpose processor (e.g., a central processing unit (CPU) or an application processor) capable of performing the relevant operations by executing one or more software programs stored in a memory device.

The term 'module' or 'part' used in the embodiments herein perform at least one function or operation, and may be implemented with a hardware or software, or implemented with a combination of hardware and software. In addition, a plurality of 'modules' or a plurality of 'parts', except for a 'module' or a 'part' which needs to be implemented with a specific hardware, may be integrated in at least one module and implemented as at least one processor.

Various elements and regions of the drawings have been schematically illustrated. Accordingly, the technical spirit of the disclosure is not limited by relative sizes and distances illustrated in the accompanied drawings.

Embodiments of the disclosure will be described in detail below with reference to the accompanying drawings to aid in the understanding of those of ordinary skill in the art.

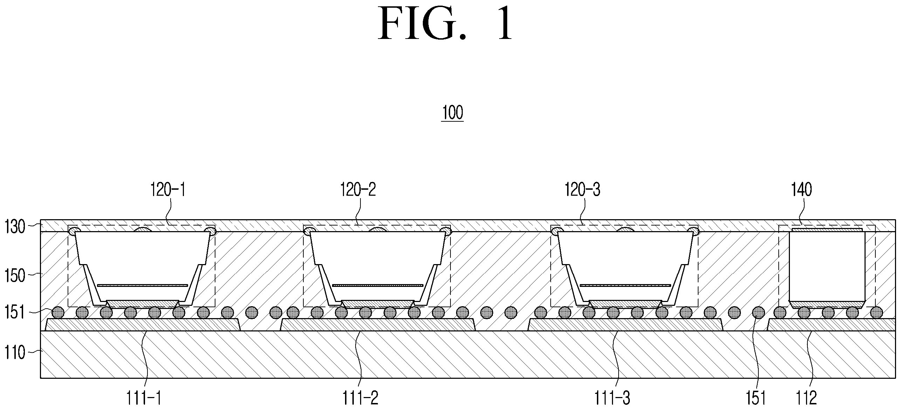

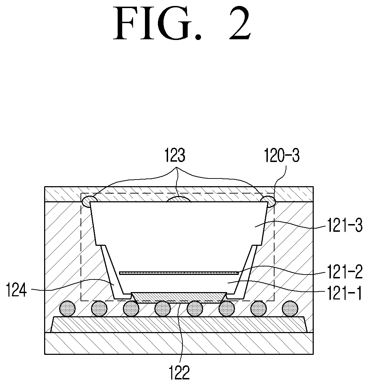

FIG. 1 is a diagram illustrating a portion of a display module 100 according to one or more embodiments of the disclosure. Further, FIG. 2 is a diagram illustrating an enlarged portion of the display module 100 shown in FIG. 1. Below, descriptions with reference to both FIG. 1 and FIG. 2 will be described.

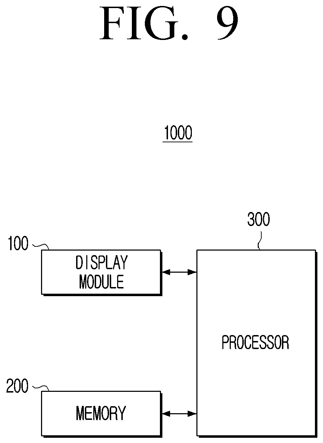

The 'display module 100' according to the disclosure may refer to a configuration (or device) which can display an image. Specifically, the display module 100 may be included in an electronic device and display an image. If the display module 100 is included in the electronic device, the display module 100 may display an image by a control of a processor 300 included in the electronic device. The electronic device including the display module 100 may be described with reference to FIG. 9, and various embodiments associated with the display module 100 will be described below.

The display module 100 may mean a whole display panel included in the electronic device, and a plurality of display modules 100 may be combined constituting one display panel. That is, the display module 100 may be included in not only an electronic device of a type similar to a digital television (TV), a monitor, a tablet personal computer (PC), a smart phone, and the like, but also in an electronic device of a type similar with a digital signage, a video wall, and the like. However, there is no particular limitation to the type of the electronic device in which the display module 100 is applied according to the disclosure.

As shown in FIG. 1, the display module 100 may include a circuit board 110, a plurality of light emitting diodes (LEDs), such as red LED 120-1, green LED 120-2, and blue LED 120-3, a top connection layer 130, a connecting element 140, and a bottom contact layer 150.

In FIG. 1, a structure including three LEDs and one connecting element 140 is shown, but this is merely a simplification of the drawings, and there is no particular limit to a number of the LEDs and a number of the connecting elements 140 included in the display module 100. For convenience of description below, the plurality of LEDs, such as red LED 120-1, green LED 120-2, and blue LED 120-3, will be first described.

The 'plurality of LEDs', such as red LED 120-1, green LED 120-2, and blue LED 120-3, may emit light by a control of the circuit board 110. Specifically, LED may refer to a light emitting device when voltage is applied in a forward direction, and the term 'LED' may mean an 'LED chip' with a packaging process in chip scale for LEDs being completed.

Referring to FIG. 2, each of the plurality of LEDs, such as red LED 120-1, green LED 120-2, and blue LED 120-3, according to the disclosure may include a plurality of semiconductor layers and a plurality of pixels electrodes, such as pixel electrode 122 and pixel electrode 123,. Further, the plurality of semiconductor layers may include an n-type semiconductor layer 121-3, a p-type semiconductor layer 121-1, and a light emitting layer 121-2

The n-type semiconductor layer 121-3 and the p-type semiconductor layer 121-1 may be implemented as compound semiconductors of Group III-V, Group II-VI, and the like. Specifically, the n-type semiconductor layer 121-3 and the p-type semiconductor layer 121-1 may be implemented as a nitride semiconductor. For example, each of the n-type semiconductor layer 121-3 and the p-type semiconductor layer 121-1 may be a n-GaN semiconductor layer and a p-GaN semiconductor layer. However, the n-type semiconductor layer 121-3 and the p-type semiconductor layer 121-1 according to the disclosure is not limited thereto, and may be formed of various materials according to various properties required by the LED.

An n-type semiconductor may be a semiconductor in which free electrons are used as carriers transferring charge, and may be created doping an n-type dopant such as Si, Ge, Sn, Te, and the like. Further, a p-type semiconductor may be a semiconductor in which holes are used as carriers transferring charge, and may be created doping a p-type dopant such as Mg, Zn, Ca, Ba, and the like.

The light emitting layer 121-2, the n-type semiconductor layer 121-3, and the p-type semiconductor layer 121-1 may be formed with various semiconductors having band gaps corresponding to a specific region within a spectrum. For example, a red LED 120-1 having a light wavelength of 600 nm to 750 nm may include one or more layers which are based on a AlInGaP-based semiconductor. Further, a blue LED 120-3 and a green LED 120-2 having light wavelengths of 450 nm to 490 nm and 500 nm to 570 nm, respectively, may include one or more layers based on a AlInGaN-based semiconductor.

The light emitting layer 121-2 may be positioned between the n-type semiconductor layer 121-3 and the p-type semiconductor layer 121-1, and may be a layer on which electrons which are carriers of the n-type semiconductor layer 121-3 and holes which are carriers of the p-type semiconductor layer 121-1 meet. When the electrons and the holes meet on the light emitting layer 121-2, a potential barrier may be formed according to the electron and the hole recombining. Then, when the electrons and the holes transition cross over the potential barrier to a low energy level according to an applied voltage, light of a wavelength corresponding thereto may be emitted.

Here, the light emitting layer 121-2 may have a multi-quantum well structure, but the disclosure is not limited thereto, and the light emitting layer 121-2 may have various structures such as a single-quantum well, a quantum-dot structure, or the like. If the light emitting layer 121-2 is formed in the multi-quantum well structure, a well layer/barrier layer of the light emitting layer 121-2 may be formed in a structure such as InGaN/GaN, InGaN/InGaN, and GaAs/AlGaAs, but the disclosure is not limited to the structures as described above. A number of quantum wells included in the light emitting layer 10 is also not necessarily limited to a specific number.

Each of the three LEDs shown in FIG. 1 shows the red LED 120-1, the green LED 120-2, and the blue LED 120-3 included in one pixel. That is, the display module 100 may divided into a plurality of pixels, and the red LED 120-1, the green LED 120-2, and the blue LED 120-3 may implement one pixel of the display module 100. However, there is no particular limitation to a number of LEDs per pixel or to an arrangement method according to the disclosure.

The 'plurality of pixels electrodes', such as pixel electrode 122 and pixel electrode 123, may refer to electrodes included in each of the plurality of LEDs, such as red LED 120-1, green LED 120-2, and blue LED 120-3, to connect the plurality of LEDs, such as red LED 120-1, green LED 120-2, and blue LED 120-3, with the circuit board 110. Specifically, the plurality of pixels electrodes, such as pixel electrode 122 and pixel electrode 123, may be connected to the top connection layer 130 (or upper connection layer, upper access layer) on individual electrodes, as electrode 111, and the plurality of LEDs, such as red LED 120-1, green LED 120-2, and blue LED 120-3, of the circuit board 110, and connect the plurality of LEDs, such as red LED 120-1, green LED 120-2, and blue LED 120-3, with the circuit board 110. In the disclosure, the term 'pixel electrode' may be a term for differentiating from electrodes (i.e., individual electrodes, as electrode 111, and a common electrode) arranged on the circuit board 110, and may be substituted with terms such as a 'pixel electrode pad'.

The plurality of pixels electrodes, such as pixel electrode 122 and pixel electrode 123, may be arranged at an upper portion and a lower portion of the plurality of semiconductor layers and connected with the plurality of semiconductor layers, and may include a first pixel electrode 122 and a second pixel electrode 123. The 'first pixel electrode 122' may refer to a pixel electrode connected to a plurality of individual electrodes, as electrode 111, of the circuit board 110, and the 'second pixel electrode 123' may refer to an electrode arranged at an opposite direction with the first pixel electrode 122 and connected to the top connection layer 130 arranged on the plurality of LEDs, such as red LED 120-1, green LED 120-2, and blue LED 120-3,.

Referring to an example of FIG. 1, the first pixel electrode 122 may be arranged at a lower portion of the plurality of LEDs, such as red LED 120-1, green LED 120-2, and blue LED 120-3, and connected to the plurality of individual electrodes, as electrode 111, of the circuit board 110. The second pixel electrode 123 may be arranged at an upper portion of the plurality of LEDs, such as red LED 120-1, green LED 120-2, and blue LED 120-3, and connected to the top connection layer 130 arranged on the plurality of LEDs, such as red LED 120-1, green LED 120-2, and blue LED 120-3,. That is, the plurality of LEDs, such as red LED 120-1, green LED 120-2, and blue LED 120-3, according to one or more embodiments of the disclosure may be implemented in a vertical type in which each of the first pixel electrode 122 and the second pixel electrode 123 included in each of the plurality of LEDs, such as red LED 120-1, green LED 120-2, and blue LED 120-3, are arranged at the upper portion and the lower portion of the plurality of LEDs, such as red LED 120-1, green LED 120-2, and blue LED 120-3,. In addition, the plurality of LEDs, such as red LED 120-1, green LED 120-2, and blue LED 120-3, may be implemented with micro LEDs of which a horizontal and vertical lengths are greater than or equal to 1 micrometer (µm) and less than or equal to 100µm. However, there is no particular limitation to the size of the plurality of LEDs, such as red LED 120-1, green LED 120-2, and blue LED 120-3, according to the disclosure.

The first pixel electrode 122 and the second pixel electrode 123 may be implemented as one or more than one. However, if the second pixel electrode 123 is implemented in plurality, there is no particular limitation to the position at which the plurality of second pixel electrodes 123 is arranged. In addition, there is no particular limitation to a number of the first pixel electrode 122 and the second pixel electrode 123 included in one LED and a number of individual electrodes, as electrode 111, corresponding thereto.

The 'circuit board 110' may refer to a board (or substrate) that includes driving circuitry for driving the plurality of LEDs, such as red LED 120-1, green LED 120-2, and blue LED 120-3, and a plurality of driving electrodes, such as electrode 111 and electrode 112,. The term 'circuit board 110' may be substituted with terms such as a 'drive board'. The plurality of LEDs, such as red LED 120-1, green LED 120-2, and blue LED 120-3, may be electrically connected to the driving circuitry arranged on the circuit board 110. The driving of the display module 100 may be performed in an active matrix method or in a passive matrix method, and the driving circuitry may be designed to match the driving method. The circuit board 110 may be one from among a thin-film transistor (TFT) substrate, a printed circuit board (PCB) 110, and a glass substrate including metal wiring, but is not necessarily limited thereto.

The driving circuitry may be connected to the plurality of driving electrodes, such as electrode 111 and electrode 112,, and may include a plurality of circuit elements such as a switching element. The switching element may be a semiconductor element that can control driving of a plurality of LED 120 included in the display module 100, and perform a role of a type of a switch for individual pixels of the display device. For example, the TFT may be used as the switching element.

The 'plurality of driving electrodes', such as electrode 111 and electrode 112, may refer to electrodes included in the circuit board 110 to connect the plurality of LEDs, such as red LED 120-1, green LED 120-2, and blue LED 120-3, with the circuit board 110. The plurality of driving electrodes, such as electrode 111 and electrode 112, may be connected with the driving circuitry by being formed at one surface of the circuit board 110, and connected with the plurality of pixels electrodes, such as pixel electrode 122 and pixel electrode 123, included in the plurality of LEDs, such as red LED 120-1, green LED 120-2, and blue LED 120-3,. That is, in the disclosure, the term driving electrode may be a term for specifying an electrode included in the circuit board 110 by differentiating from the pixel electrode included in the plurality of LEDs, such as red LED 120-1, green LED 120-2, and blue LED 120-3,, and may be substituted with terms such as the 'driving electrode pad'. According to a description method, the plurality of driving electrodes, such as electrode 111 and electrode 112, and the circuit board 110 may be divided into separate configurations, and the plurality of driving electrodes, such as electrode 111 and electrode 112, may be described as being formed on the circuit board 110.

The plurality of driving electrodes, such as electrode 111 and electrode 112, may include the plurality of individual electrodes, as electrode 111, and a plurality of common electrodes, such as electrode 112, . Here, the 'individual electrodes', such as electrode 111, may refer to driving electrodes which are individually connected to each of the plurality of LEDs, such as red LED 120-1, green LED 120-2, and blue LED 120-3,, and the 'common electrodes', such as electrode 112, may refer to driving electrodes which are commonly connected to two or more LEDs. Below, it may be described assuming that the display module 100 includes the plurality of common electrodes, such as electrode 112, , but the common electrode 112 may be implemented as one according to an embodiment.

The plurality of individual electrodes, as electrode 111, and the plurality of common electrodes, such as electrode 112, may have opposite polarities from each other. For example, the plurality of individual electrodes, as electrode 111, may be an anode and the plurality of common electrodes, such as electrode 112, may be a cathode. Conversely, the plurality of individual electrodes, as electrode 111, may be a cathode and the plurality of common electrodes, such as electrode 112, may be an anode.

For example, as shown in FIG. 1, if the plurality of LEDs, includes the red LED 120-1, the green LED 120-2, and the blue LED 120-3, each of the plurality of individual electrodes, as electrode 111, may be used in the driving of one from among the red LED 120-1, the green LED 120-2, and the blue LED 120-3, and the plurality of common electrodes, such as electrode 112, may be used in the driving of the red LED 120-1, the green LED 120-2, and the blue LED 120-3.

The 'top connection layer 130' may be arranged at the upper portion of the plurality of LEDs, such as red LED 120-1, green LED 120-2, and blue LED 120-3,, and refer to a configuration for connecting the circuit board 110 with the plurality of LEDs, such as red LED 120-1, green LED 120-2, and blue LED 120-3,. Specifically, the top connection layer 130 may be connected to the second pixel electrode 123 by being arranged on the plurality of LEDs, such as red LED 120-1, green LED 120-2, and blue LED 120-3,. In addition, as described below, the top connection layer 130 may be connected with the common electrode, such as electrode 112, through a plurality of connecting elements 140. The top connection layer may include a transparent electrode. That is, at least a portion of a region of the top connection layer 130 may be formed transparently for light to be emitted outside of the display module 100.

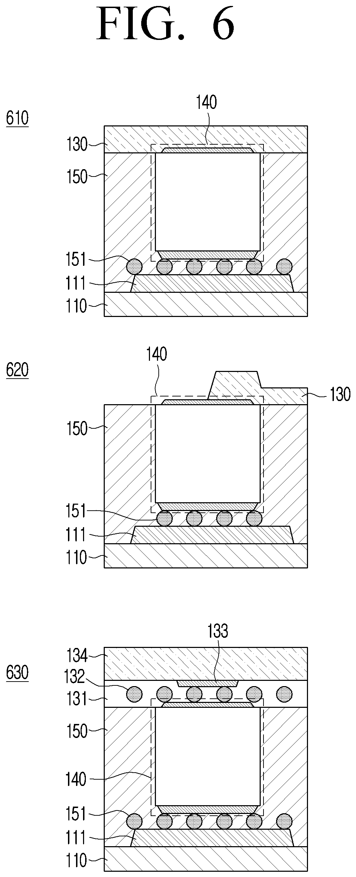

For example, the top connection layer 130 may be at least one from among a first top connection layer 130 which includes indium tin oxide (ITO), and a second top connection layer 130 which includes a transparent ACF and a glass substrate. One or more embodiments associated with the top connection layer 130 will be described in greater detail with reference to FIG. 6.

The 'plurality of connecting elements 140' may refer to elements for connecting the top connection layer 130 with the common electrode, such as electrode 112. The term 'connecting element 140' may be substituted with terms such as a 'connecting part'. The upper portion of each of the plurality of connecting elements 140 may be connected with the top connection layer 130 and the top connection layer 130 may be connected to the second pixel electrode 123 of the plurality of LEDs, such as red LED 120-1, green LED 120-2, and blue LED 120-3,. In addition, a lower portion of each of the plurality of connecting elements 140 may be connected to the common electrode, such as electrode 112, of the circuit board 110. Accordingly, the plurality of LEDs, such as red LED 120-1, green LED 120-2, and blue LED 120-3, may be connected with the common electrode, such as electrode 112, of the circuit board 110 through the top connection layer 130 and the plurality of connecting elements 140.

The connecting element 140 may be arranged in plurality in terms of the whole display module 100. Accordingly, it will be described below assuming that the display module 100 includes the plurality of connecting elements 140, but the connecting element 140 may be implemented as one according to an embodiment.

As described above, the display module 100 may be divided into a plurality of pixels, and each of the plurality of pixels may correspond to the red LED 120-1, the green LED 120-2, the blue LED 120-3, and one connecting element 140 from among the plurality of connecting elements 140. That is, together with the red LED 120-1, the green LED 120-2, and the blue LED 120-3 respectively included in one pixel, the connecting element 140 used in the driving of the red LED 120-1, the green LED 120-2, and the blue LED 120-3 is shown together therewith.

As shown in FIG. 1, the connecting element 140 may have a cylindrical or rectangular cylinder shape and accordingly, may be referred to as a so-called 'stud'. However, there is not necessarily any particular limitation to the shape of the connecting element 140.

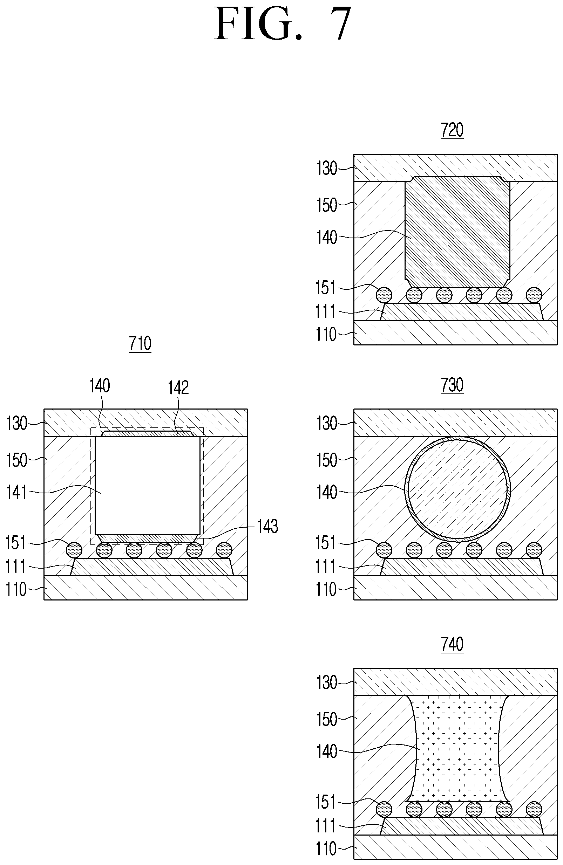

The plurality of connecting elements 140 may include the semiconductor layer and a first connecting element 140 including an upper electrode arranged at an upper portion of the semiconductor layer and connected to the top connection layer 130 and a lower electrode arranged at the lower portion of the semiconductor layer and connected to the common electrode 112. Here, the semiconductor layer included in the plurality of connecting elements 140 may include at least one from among GaN, GaP, GaAs, and Si. In addition, the plurality of connecting elements 140 may include at least one from among a second connecting element 140 including metal, and a third connecting element 140 including a metal coated polymer. One or more embodiments associated with the plurality of connecting elements 140 will be described in greater detail with reference to FIG. 7.

The 'bottom contact layer 150' may be arranged at a region that includes the lower portion of the plurality of LEDs, such as red LED 120-1, green LED 120-2, and blue LED 120-3,, and may refer to a configuration which connects the circuit board 110 with the plurality of LEDs, such as red LED 120-1, green LED 120-2, and blue LED 120-3, and the plurality of connecting elements 140. The bottom contact layer 150 may be arranged on the circuit board 110, and specifically, may be formed between a region at which the driving electrodes are not arranged on the circuit board 110 and the plurality of LEDs, such as red LED 120-1, green LED 120-2, and blue LED 120-3,. Accordingly, the bottom contact layer 150 may connect the plurality of individual electrodes, as electrode 111, included in the circuit board 110 and the plurality of first pixel electrodes 122 included in each of the plurality of LEDs, such as red LED 120-1, green LED 120-2, and blue LED 120-3,, and connect the plurality of connecting elements 140 with the plurality of common electrodes, such as electrode 112, included in the circuit board 110.

Specifically, the bottom contact layer 150 may be a film configured with a portion which is an electric conductor and a portion which is an insulator. For example, the bottom contact layer 150 may be a film referred to as a so-called anisotropic conductive film (ACF), and may include a plurality of conductive balls 151 and an adhesive. However, the above is not limited thereto, and so long as it is a configuration that can connect the circuit board 110 with the plurality of LEDs, such as red LED 120-1, green LED 120-2, and blue LED 120-3, and the plurality of connecting elements 140, it may correspond to the bottom contact layer 150 according to the disclosure.

The plurality of conductive balls 151 may refer to conductive particles of a fine size which are dispersed within the bottom contact layer 150. The plurality of conductive balls 151 may connect the plurality of individual electrodes, as electrode 111, to the first pixel electrode 122, connect the plurality of common electrodes, such as electrode 112, to the plurality of connecting elements 140, and connect plurality of common electrodes, such as electrode 112, to the plurality of connecting elements 140. In FIG. 1 an FIG. 2, reference numeral of one conductive ball has been described, but configurations of the same form may all indicate conductive balls.

For example, the plurality of conductive balls 151 may include at least one from among a metal, a carbon nanotube, and a conductive polymer particle, and have a diameter of 3 to 15 micrometers. The plurality of driving electrodes, such as electrode 111 and electrode 112, included in the circuit board 110 and the plurality of first pixel electrodes 122 included in each of the plurality of LEDs, such as red LED 120-1, green LED 120-2, and blue LED 120-3, may be electrically connected through at least one conductive ball from among the plurality of conductive balls 151.

The adhesive may perform a role of fixing the bottom contact layer 150 to a plurality of regions. The adhesive may be a thermosetting adhesive, and may fix the bottom contact layer 150 to a plurality of regions by hardening when heat and pressure is applied. Specifically, the adhesive may include an epoxy resin and a curing agent which cures the adhesive by reacting with the epoxy resin. In addition thereto, the bottom contact layer 150 may further include a supplementary material for adjusting curing speed or heat conductivity of the bottom contact layer 150.

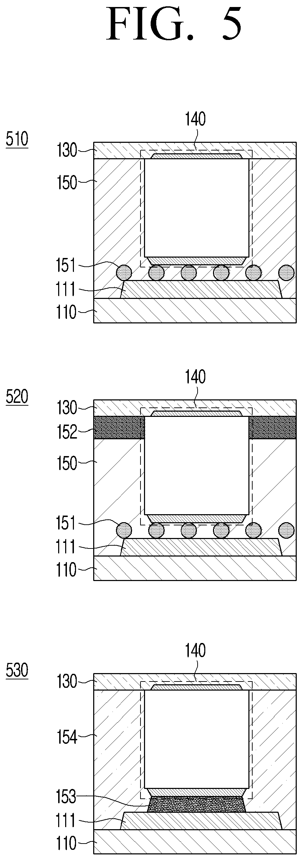

As shown in FIG. 1, the bottom contact layer 150 may be arranged on the circuit board 110 and formed to fill a gap between the plurality of LEDs, such as red LED 120-1, green LED 120-2, and blue LED 120-3,. However, the above is not limited thereto, and the bottom contact layer 150 may be arranged on a plurality of local regions which are spaced apart on the circuit board 110. One or more embodiments associated with the bottom contact layer 150 will be described in greater detail with reference to FIG. 5.

A structure of the display module 100 as shown in FIG. 1 and FIG. 2 will be described in greater detail below. First, it may be assumed below that the plurality of LEDs, such as red LED 120-1, green LED 120-2, and blue LED 120-3, is formed such that the p-type semiconductor layer 121-1 is arranged at the lower portion (i.e., an opposite direction of the light emitting surface) of the light emitting layer 121-2, and the n-type semiconductor layer 121-3 is arranged at the upper portion (i.e., direction of the light emitting surface) of the light emitting layer 121-2.

FIG. 1 and FIG. 2 show an embodiment of when the plurality of individual electrodes, as electrode 111, is an anode, and the plurality of common electrodes, such as electrode 112, is a cathode. In this case, if the plurality of LEDs, such as red LED 120-1, green LED 120-2, and blue LED 120-3, is arranged as in the examples of FIG. 1 and FIG. 2, the plurality of individual electrodes, as electrode 111, which is an anode may be connected with the p-type semiconductor layer 121-1 of each of the plurality of LEDs, such as red LED 120-1, green LED 120-2, and blue LED 120-3,, and the plurality of common electrodes, such as electrode 112, which is a cathode may be connected with the n-type semiconductor layer 121-3 of each of the plurality of LEDs, such as red LED 120-1, green LED 120-2, and blue LED 120-3, through the plurality of connecting elements 140 and the top connection layer 130. In addition, the p-type semiconductor layer 121-1 may be connected with the first pixel electrode 122, and the n-type semiconductor layer 121-3 may be connected with the second pixel electrode 123.

The second pixel electrode 123 included in each of the plurality of LEDs, such as red LED 120-1, green LED 120-2, and blue LED 120-3, may be one, and in this case, the second pixel electrode 123 may be arranged at a center portion of a top surface of the plurality of LEDs, such as red LED 120-1, green LED 120-2, and blue LED 120-3,. Conversely, as shown in FIG. 1 and FIG. 2, the second pixel electrode 123 included in each of the plurality of LEDs, such as red LED 120-1, green LED 120-2, and blue LED 120-3, may be in plurality. If the second pixel electrode 123 is in plurality, the plurality of second pixel electrodes 123 may be arranged at different regions of the light emitting surface of each of the plurality of LEDs, such as red LED 120-1, green LED 120-2, and blue LED 120-3,. The above is to secure connectivity with the top connection layer 130 without limiting the light emitting surfaces of the plurality of LEDs, such as red LED 120-1, green LED 120-2, and blue LED 120-3,.

More specifically, the second pixel electrode 123 may be implemented as three, and one second pixel electrode 120 from among the three second pixel electrodes 123 may be arranged at the center portion of the top surface of the LEDs, and the other two second pixel electrodes 123 may be arranged at an outer portion of the top surface of the LEDs. Here, the outer portion may be a region corresponding to two vertices which are not adjacent to each other from among the quadrangle vertices corresponding to the top surfaces of the LEDs. In addition, if the second pixel electrode 123 is arranged at the outer portion of the top surfaces of the LEDs, the second pixel electrode 123 may be formed to surround not only the top surface but also a side surface portion in the vicinity of the outer portion. The above is for a connection between a portion of the LEDs and the top connection layer 130 to be carried out through the at least one second pixel electrode 123 even if the portion of the LEDs from among the plurality of LEDs, such as red LED 120-1, green LED 120-2, and blue LED 120-3, are tilted to any one direction when transferring the plurality of LEDs, such as red LED 120-1, green LED 120-2, and blue LED 120-3, to the circuit board 110.

The plurality of LEDs, such as red LED 120-1, green LED 120-2, and blue LED 120-3, may further include a reflection layer 124 at a side wall of the plurality of LEDs, such as red LED 120-1, green LED 120-2, and blue LED 120-3,. Specifically, as shown in FIG. 1 and FIG. 2, the plurality of LEDs, such as red LED 120-1, green LED 120-2, and blue LED 120-3, may further include the reflection layer 124 arranged at a surrounding of the light emitting layer 121-2. Here, the reflection layer 124 may perform a role of increasing light emitting efficiency of LEDs by reflecting light emitted from the light emitting layer 121-2 of the LEDs toward a light emitting surface direction of the LED element. For example, the reflection layer 124 may be formed in a metal reflector or a distributed-bragg-reflector structure. For example, the reflection layer 124 may be formed in the metal reflector or the distributed-bragg-reflector structure.

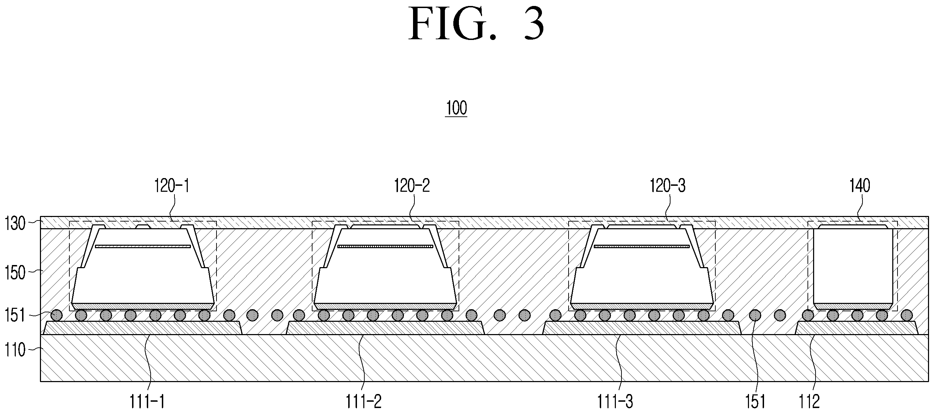

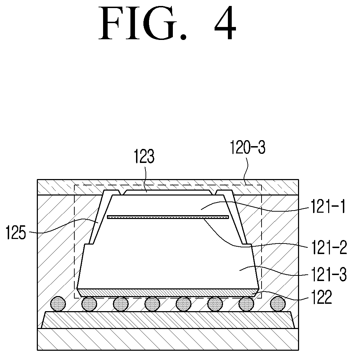

FIG. 3 is a diagram illustrating a portion of the display module 100 according to one or more embodiments of the disclosure. Further, FIG. 4 is a diagram illustrating an enlarged portion of the display module 100 shown in FIG. 3. Below, descriptions with reference to both FIG. 3 and FIG. 4 will be described below, but descriptions that overlap with that described with reference to FIG. 1 and FIG. 2 will be omitted.

While FIG. 1 and FIG. 2 are embodiments of when the plurality of individual electrodes, as electrode 111, is an anode, and the plurality of common electrodes, such as electrode 112, is a cathode, FIG. 3 and FIG. 4 show embodiments of when the plurality of individual electrodes, as electrode 111, is a cathode, and the plurality of common electrodes, such as electrode 112, is an anode. In this case, if the plurality of LEDs, such as red LED 120-1, green LED 120-2, and blue LED 120-3, is arranged as shown in FIG. 3 and FIG. 4, the plurality of individual electrodes, as electrode 111, which is a cathode may be connected with the n-type semiconductor layer 121-3 of each of the plurality of LEDs, such as red LED 120-1, green LED 120-2, and blue LED 120-3,, and the plurality of common electrodes, such as electrode 112, which is an anode may be connected with the p-type semiconductor layer 121-1 of each of the plurality of LEDs, such as red LED 120-1, green LED 120-2, and blue LED 120-3, through the plurality of connecting elements 140 and the top connection layer 130. In addition, the p-type semiconductor layer 121-1 may be connected with the second pixel electrode 123, and the n-type semiconductor layer 121-3 may be connected with the first pixel electrode 122.

In the embodiments of FIG. 3 and FIG. 4, the second pixel electrode 123 included in the red LED 120-1 may be metal, and the second pixel electrode 123 included in the green LED 120-2 and the blue LED 120-3 may be an ITO. Due to the characteristics of a material, if the ITO is used as an electrode that is connected to the p-type semiconductor layer 121-1 of the red LED 120-1, the ITO may not be used as the second pixel electrode 123 due to not being able to secure electric properties suitable to the driving of the red LED 120-1 and accordingly, a metal may be used. Conversely, even if the ITO is used as the electrode that is connected to the p-type semiconductor layer 121-1 of the green LED 120-2 and the blue LED 120-3, the ITO may be used as the second pixel electrode 123 due to being able to secure the electric properties suitable to the driving of the green LED 120-2 and the blue LED 120-3.

The plurality of LEDs, such as red LED 120-1, green LED 120-2, and blue LED 120-3, may further include an insulation layer 125 at the side wall of the plurality of LEDs, such as red LED 120-1, green LED 120-2, and blue LED 120-3,. Specifically, as shown in FIG. 3 and FIG. 4, the plurality of LEDs, such as red LED 120-1, green LED 120-2, and blue LED 120-3, may further include the insulation layer 125 arranged at the surrounding of the light emitting layer 121-2. Here, the insulation layer 125 may stabilize element properties of the plurality of LEDs, such as red LED 120-1, green LED 120-2, and blue LED 120-3,. For example, the insulation layer 125 may include materials with superior electrical insulating properties such as silicon dioxide (SiO2). In the embodiments of FIG. 3 and FIG. 4, because the plurality of LEDs, such as red LED 120-1, green LED 120-2, and blue LED 120-3, is mounted in reverse unlike the embodiments of FIG. 1 and FIG. 2, the surrounding of the light emitting layer 121-2 may be adjacent to the light emitting surface. Accordingly, arranging the insulation layer 125 at the surrounding of the light emitting layer 121-2 may be effective from a light emitting efficiency aspect and a stabilization of element aspect compared to when arranging the reflection layer 125 at the surrounding of the light emitting layer 121-2. Although an embodiment of the plurality of LEDs, such as red LED 120-1, green LED 120-2, and blue LED 120-3, further comprising the reflection layer 124 or the insulation layer 125 has been described above, various configurations for enhancing the properties of the plurality of LEDs, such as red LED 120-1, green LED 120-2, and blue LED 120-3, may be further included in addition thereto.

It has been described above assuming that all the plurality of LEDs, such as red LED 120-1, green LED 120-2, and blue LED 120-3, included in a display panel are all LED elements of a vertical type, but the disclosure is not limited thereto. For example, a portion from among the plurality of LEDs, such as red LED 120-1, green LED 120-2, and blue LED 120-3, included in the display panel may be LEDs of the vertical type, and another portion (remaining portion?) may be LEDs of a flip-chip type.

In addition, even if the plurality of LEDs, such as red LED 120-1, green LED 120-2, and blue LED 120-3, are all implemented as LEDs of the vertical type when manufacturing the display module 100, the plurality of LEDs, such as red LED 120-1, green LED 120-2, and blue LED 120-3, included in the display panel may be implemented in a combination of the vertical type and the flip-chip type after repairing the LED in which a failure has occurred. For example, if a failure for a portion of the LEDs has occurred, the repair may be completed by arranging an LED of the flip-chip type in an adjacent region after removing the top connection layer 130 over the LED in which failure has occurred, and accordingly, the repair for the display module 100 may be easily carried out even when the top connection layer 130 such as the ITO is arranged at the upper portion of the plurality of LEDs, such as Red LED 120-1, green LED 120-2, and blue LED 120-3,.

Although the structure of FIG. 1 and FIG. 2 and the structure of FIG. 3 and FIG. 4 have been divided and described above, this is merely to describe in detail the embodiments according to the disclosure, and it should be noted that the disclosure is not limited to the specific embodiments. In other words, a display module, that includes the circuit board including the plurality of individual electrodes and the plurality of common electrodes having opposite polarity with the plurality of individual electrodes, the plurality of LEDs including each of the first pixel electrode connected to the plurality of individual electrodes with the plurality of semiconductor layers and the second pixel electrode arranged at the opposite direction from the first pixel electrode, the top connection layer arranged on the plurality of LEDs and connected to the second pixel electrode, and the plurality of connecting elements for connecting the top connection layer with the common electrode, may be the display module according to the disclosure.

According to the various embodiments described above with reference to FIG. 1, FIG. 2, FIG. 3, and FIG. 4 above, a bonding area between the LED and the circuit board 110 may be widened, and stability of a LED manufacturing process may be improved. Further, performance and stability of ultra-small to super ultra-small LED display modules 100 may be improved accordingly.

Specifically, in the display module 100 according to the disclosure, because one electrode arranged at the lower portion of the LED of the vertical type is bonded to the circuit board 110, the bonding area compared to when two electrodes arranged at the lower portion of the LED of the flip-chip type are bonded to the circuit board 110 may increase at minimum by two folds assuming that lower areas of the LEDs are the same. In addition, stability of a process associated with a shift and the like which can be generated during a transfer and bonding process may be remarkably improved because the two electrodes are not arranged in the same direction. Furthermore, if the LED of the vertical type is used according to the disclosure, unlike when using the LED of the flip-chip type, the light emitting efficiency of the LED may be relatively increased due to an effective light emitting area becoming wider because a mesa hole is not formed.

FIG. 5 is a diagram illustrating one or more embodiments associated with the bottom contact layer 150 according to the disclosure.

In FIG. 5, only a portion of the top connection layer 130, one connecting element 140, a portion of the bottom contact layer 150, and a portion of the circuit board 110 according to the disclosure have been shown, but this is merely for convenience of description, and the various embodiments described with reference to FIG. 5 may be applied to the whole of the display module 100.

As described above, the bottom contact layer 150 may be arranged at a region that includes the lower portion of the plurality of LEDs, such as red LED 120-1, green LED 120-2, and blue LED 120-3, connect the plurality of first pixel electrodes 122 included in each of the plurality of LEDs, such as red LED 120-1, green LED 120-2, and blue LED 120-3, with the plurality of individual electrodes, as electrode 111, included in the circuit board 110, and connect the plurality of connecting elements 140 with the plurality of common electrodes, such as electrode 112, included in the circuit board 110.

As shown in 510 of FIG. 5, the bottom contact layer 150 may be a film referred to as a so-called anisotropic conductive film (ACF), and may include the plurality of conductive balls 151 and the adhesive. Specifically, the connection between the circuit board 110 and the plurality of LEDs, such as red LED 120-1, green LED 120-2, and blue LED 120-3,, and the connection between the circuit board 110 and the plurality of connecting elements 140 may be performed through the plurality of conductive balls 151, and the remaining region excluding the region in which the plurality of conductive balls 151 is formed may be filled with the adhesive (or adhesive and a reinforcement material).

The adhesive of the bottom contact layer 150 may show a black color, and may be transparent. Specifically, if the bottom contact layer 150 shows the black color, a light interference phenomenon between a pixel or a sub pixel of the display module 100, that is, an occurrence of a cross-talk phenomenon may be reduced by applying the black color to the whole of the display module 100.

As shown in 520 of FIG. 5, the bottom contact layer 150 may include a transparent ACF 150 and a black matrix (BM) 152. Specifically, the adhesive of the bottom contact layer 150 may be transparent, and in this case, at an upper portion of the adhesive, the BM 152 may be arranged to prevent the light interference phenomenon between the pixels or the sub pixels of the display module 100.

As shown in 530 of FIG. 5, the bottom contact layer 150 may include a metal layer 153 and a molding 154. Specifically, the bottom contact layer 150 may include the metal layer for connecting the plurality of first pixel electrodes 122 with the plurality of individual electrodes 111, and a metal layer for connecting the plurality of connecting elements 140 with the plurality of common electrodes, such as electrode 112, . That is, the connection between the circuit board 110 and the plurality of LEDs, such as red LED 120-1, green LED 120-2, and blue LED 120-3,, and the connection between the circuit board 110 and the plurality of connecting elements 140 may be performed through a metallic bonding by a metal layer 153 rather than the plurality of conductive balls 151. For example, the metallic bonding may be implemented by techniques such as, for example, and without limitation, Eutectic bonding, soldering, die attach (dotting), conductive ink, and the like. If the bottom contact layer 150 includes the metal layer 153, the remaining regions excluding the region in which the metal layer is arranged may protect the plurality of LEDs, such as red LED 120-1, green LED 120-2, and blue LED 120-3, and may be filled with molding (or encapsulation) 154 for providing stability of the display module 100.

Although various embodiments of the bottom contact layer 150 have been described with reference to FIG. 5 above, the above is merely a simple example, and so long as it is a configuration that can connect the circuit board 110 with the plurality of LEDs, such as red LED 120-1, green LED 120-2, and blue LED 120-3, and the plurality of connecting elements 140, it may correspond to the bottom contact layer 150 according to the disclosure regardless of the type thereof.

FIG. 6 is a diagram illustrating one or more embodiments associated with the top connection layer 130 according to the disclosure.

As shown in FIG. 5, in FIG. 6, only a portion of the top connection layer 130, one connecting element 140, a portion of the bottom contact layer 150, and a portion of the circuit board 110 according to the disclosure have been illustrated. However, this is merely for convenience of description, and the various embodiments described with reference to FIG. 6 may be applied to the whole of the display module 100.

As described above, the 'top connection layer 130' may be arranged on the plurality of LEDs, such as red LED 120-1, green LED 120-2, and blue LED 120-3, and connected to the second pixel electrode 123, and may be connected with the common electrode 112 through the plurality of connecting elements 140. The top connection layer may include the transparent electrode.

As shown in example 610 of FIG. 6, the top connection layer 130 may be formed as one layer covering a whole upper portion of the display module 100. In this case, the one layer may include indium tin oxide (ITO). Because ITO, as a transparent conductive oxide, has properties which can transmit light while conducting electricity, it may be used as a transparent electrode. In addition to ITO, materials having light transmissivity together with conductivity such as carbon-based materials and carbon nanofibers may be included in the top connection layer 130.

As shown in example 620 of FIG. 6, the top connection layer 130 may contact a portion of a region on the upper electrode of the connecting element 140 (or LED). For example, the top connection layer 130 may be ITO patterned to be formed only at the portion of the region on the upper portion of the connecting element 140 (or LED). In this case, because the top connection layer 130 does not cover the whole light emitting surface while being connected with the plurality of LED elements 120, light emitting efficiency may be improved compared to when covering the whole light emitting surface.

As shown in example 630 of FIG. 6, the top connection layer 130 may include an ACF 131 and a glass substrate 134. Specifically, the top connection layer 130 may include the ACF 131 described in FIG. 5, and may be connected with the plurality of LEDs, such as red LED 120-1, green LED 120-2, and blue LED 120-3, and the plurality of connecting elements 140 through the plurality of conductive balls 151 included in the ACF 131. In this case, an upper portion of the ACF 131 may be covered with the glass substrate 134, and the glass substrate 134 may be connected with the plurality of conductive balls 151 through an upper electrode 133.

In the above, various embodiments on the top connection layer 130 have been described with reference to FIG. 6, but the above are merely examples, and so long as it is a configuration that can connect the circuit board 110 with the plurality of LEDs, such as red LED 120-1, green LED 120-2, and blue LED 120-3,, it may correspond to the top connection layer 130 according to the disclosure regardless of the type thereof.

FIG. 7 is a diagram illustrating one or more embodiments associated with the connecting element 140 according to the disclosure.

Like FIG. 5 and FIG. 6, in FIG. 7, only a portion of the top connection layer 130, one connecting element 140, a portion of the bottom contact layer 150, and a portion of the circuit board 110 according to the disclosure have been shown. However, the above is merely for convenience of description, and the various embodiments described with reference to FIG. 7 may be applied to the whole display module 100.

As described above, the upper portion of each of the plurality of connecting elements 140 may be connected with the top connection layer 130 and the top connection layer 130 may be connected to the second pixel electrode 123 of the plurality of LEDs, such as red LED 120-1, green LED 120-2, and blue LED 120-3,. In addition, a lower portion of each of the plurality of connecting elements 140 may be connected to the common electrode 112 of the circuit board 110.

As shown in example 710 of FIG. 7, the plurality of connecting elements 140 may include a semiconductor layer 141, an upper electrode 142 arranged at the upper portion of the semiconductor layer and connected to the top connection layer 130, and a lower electrode 143 arranged at the lower portion of the semiconductor layer and connected to the common electrode 112. Here, the semiconductor layer included in the plurality of connecting elements 140 may include at least one from among GaN, GaP, GaAs, and Si, but is not limited thereto.

As shown in example 720 of FIG. 7, the plurality of connecting elements 140 may be formed only of metal. In this case, the metal may include at least one from among the metals with high conductivity such as, for example, and without limitation, gold, silver, copper, aluminum, and the like.

As shown in example 730 of FIG. 7, the plurality of connecting elements 140 may be formed of a metal coated polymer. In this case, the coated metal may be gold, and at least one from among the highly conductive metals may be coated in addition thereto.

As shown in example 740 of FIG. 7, the plurality of connecting elements 140 may be formed by dotting of a conductive ink. In this case, the dotted metal may be silver, and at least one from among the highly conductive metals may be dotted in addition thereto.

Various embodiments on the connecting element 140 have been described with reference to FIG. 7 above, but the above are merely examples, and so long as it is a configuration that can connect the top connection layer 130 with the common electrode 112, it may correspond to the connecting element 140 according to the disclosure regardless of the type thereof.

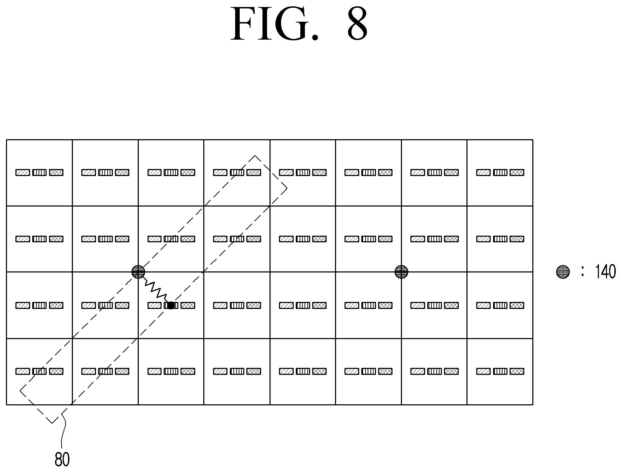

FIG. 8 is a diagram illustrating one or more embodiments associated with a number and position of the connecting element 140 according to the disclosure.

In FIG. 1 and FIG. 3, various embodiments according to the disclosure have been described assuming that the red LED 120-1, the green LED 120-2, the blue LED 120-3, and one connecting element 140 correspond to one pixel. However, the connecting element 140 according to the disclosure may not necessarily be arranged for each pixel.

Specifically, a number and position of the plurality of connecting elements 140 may be determined based on a voltage drop when driving the display module 100. Here, the voltage drop may be determined according to a distance with the connecting element 140, a thickness of ITO which is the top connection layer 130, and the like. For example, the further the pixel is the distanced from the connecting element, driving according to the voltage drop may be limited, and the thicker the thickness of the ITO is, a range of the pixel that can defend against the voltage drop may become wider.

In addition, in determining the number and position of the plurality of connecting elements 140, it may be necessary to determine the above taking into consideration whether driving of a pixel which is arranged at an outermost corner of the display module can be carried out normally according to the voltage drop of when driving the display module 100. In addition thereto, performance, process convenience, manufacturing costs, and the like of the display module 100 may be considered in determining the number and position of the plurality of connecting elements 140.

Referring to an example in FIG. 8, the plurality of connecting elements 140 may be arranged one by one for every 4x4 pixel. Here, a region 80 may indicate a distance which the corresponding connecting element 140 can cover when driving the display module 100. That is, in the example of FIG. 8, because one connecting element 140 can cover the pixels of a distance corresponding to a diagonal length of the 4x4 pixel, the plurality of connecting elements 140 may be arranged one by one at a center portion thereof for every 4x4 pixel. However, FIG. 8 is merely one example, and the number and position of the plurality of connecting elements 140 may be variably determined according to factors as described above.

In FIG. 1 and FIG. 3, the plurality of LEDs, such as red LED 120-1, green LED 120-2, and blue LED 120-3, have been shown as arranged in one line, but the plurality of LEDs, such as red LED 120-1, green LED 120-2, and blue LED 120-3, may be arranged in various methods within each of the pixels, and there is no particular limitation to even a position relationship between the plurality of LEDs, such as red LED 120-1, green LED 120-2, and blue LED 120-3, and the connecting elements 140.

FIG. 9 is a diagram illustrating an electronic device which includes the display module 100 according to the disclosure.

As shown in FIG. 9, the electronic device according to the disclosure may include the display module 100, a memory 200, and the processor 300. However, configurations as shown in FIG. 15 are merely examples, and in implementing the disclosure, in addition to the configurations as shown in FIG. 15, new configurations such as, for example, and without limitation, a communicator, an inputter, an outputter, or the like may be added or a portion of the configurations may be omitted.

The display module 100 may refer to a configuration that can display an image, and have a structure according to the various embodiments of FIG. 1 to FIG. 8 specifically. Because the display module 100 has been described above with reference to FIG. 1 to FIG. 13, redundant descriptions thereof for the same description will be omitted. That is, the various embodiments described above with reference to FIG. 1 to FIG. 13 may be applied likewise for the display module 100 included in the electronic device.

In the memory 200, at least one instruction with respect to the electronic device may be stored. Further, the memory 200 may be stored with an operating system (O/S) for driving the electronic device. In addition, the memory 200 may be stored with various software programs or applications for operating the electronic device according to the various embodiments of the disclosure. Further, the memory 200 may include a semiconductor memory 200 such as a flash memory 200 or a magnetic storage medium such as a hard disk.

Specifically, various software modules for operating the electronic device according to the various embodiment of the disclosure may be stored in the memory 200, and the processor 300 may control an operation of the electronic device by executing various software modules stored in the memory 200. That is, the memory 200 may be accessed by the processor 300, and reading/writing/modifying/deleting/updating of data may be performed by the processor 130.

The term 'memory 200' in the disclosure may be used as a meaning that includes the memory 200, a read only memory (ROM) in the processor 300, a random access memory (RAM), or a memory card mounted to the electronic device.

According to one or more embodiments, image data and instructions for displaying an image in the display module 100 based on the image data may be stored in the memory 200. In addition thereto, various information necessary within a range for achieving the object of the disclosure may be stored in the memory 200, and the information stored in the memory 200 may be received from an external device or updated according to being input by a user.

The processor 300 may control an overall operation of the electronic device. Specifically, the processor 300 may be connected with a configuration of the electronic device including the display module 100 and the memory 200, and by executing at least one instruction stored in the memory 200 as described above, control the overall operation of the electronic device.

The processor 300 may be implemented in various methods. For example, the processor 300 may be implemented as at least one from among an application specific integrated circuit (ASIC), an embedded processor 300, a microprocessor 300, a hardware control logic, a hardware finite state machine (FSM), and a digital signal processor (DSP) 300. In the disclosure, the term 'processor 300' may be used as a meaning that includes a central processing unit (CPU), a graphic processing unit (GPU), a main processing unit (MPU), and the like.

According to one or more embodiments, the processor 300 may control the display module 100 to display an image based on the image data stored in the memory 200. Specifically, the processor 300 may include at least one timing controller for controlling the driving of the plurality of LEDs, such as red LED 120-1, green LED 120-2, and blue LED 120-3, and a panel driver for controlling the driving of the display panel.

The timing controller may control the panel driver to control the plurality of LEDs, such as red LED 120-1, green LED 120-2, and blue LED 120-3,. Specifically, the timing controller may adjust the image data stored in the memory 200 to a signal required in the panel driver, and by transmitting the adjusted signal to the panel driver, have the panel driver to control the driving the plurality of LEDs, such as red LED 120-1, green LED 120-2, and blue LED 120-3,.

The panel driver may control the driving of the plurality of LEDs, such as red LED 120-1, green LED 120-2, and blue LED 120-3, based on a signal received from the timing controller. For example, the panel driver may include a plurality of driving integrated circuits (IC) and a plurality of pixel driving circuits. Further, the plurality of driving ICs may control, by driving the plurality of pixel driving circuits, emission of a plurality of light emitting elements of the plurality of LEDs, such as red LED 120-1, green LED 120-2, and blue LED 120-3, connected to each of the plurality of pixel driving circuits.

Respective elements (e.g., a module or a program) according to the various embodiments of the disclosure as described in the above may be configured of a single entity or a plurality of entities, and a portion of sub-elements from among the above-mentioned sub-elements may be omitted, or other sub-elements may be further included in the various embodiments. Alternatively or additionally, a portion of elements (e.g., modules or programs) may be integrated into one entity to perform the same or similar functions performed by the respective corresponding elements prior to integration.

Operations performed by a module, a program, or other element, in accordance with the various embodiments, may be executed sequentially, in parallel, repetitively, or in a heuristically manner, or at least a portion of the operations may be performed in a different order, omitted, or a different operation may be added.

While the disclosure has been illustrated and described with reference to example embodiments thereof, it will be understood that the various example embodiments are intended to be illustrative, not limiting. It will be understood by those skilled in the art that various changes in form and details may be made therein without departing from the true spirit and full scope of the disclosure, including the appended claims and their equivalents.

## Claims

1. A display module comprising:
a circuit board comprising a plurality of individual electrodes and a plurality of common electrodes having a polarity opposite to a polarity of the plurality of individual electrodes;
a plurality of light emitting diodes (LEDs), each LED of the plurality of LEDs comprising a plurality of semiconductor layers, a first pixel electrode connected to the plurality of individual electrodes, and a second pixel electrode at an opposite direction from the first pixel electrode, respectively;
a top connection layer on the plurality of LEDs and connected to the second pixel electrode; and
a plurality of connecting elements connecting the top connection layer to the plurality of common electrodes.

2. The display module of claim 1, wherein the plurality of LEDs comprises a red LED, a green LED, and a blue LED,
wherein each of the plurality of individual electrodes is configured to drive one from among the red LED, the green LED, and the blue LED, and
wherein the plurality of common electrodes is configured to drive the red LED, the green LED, and the blue LED.

3. The display module of claim 2, wherein the display module is divided into a plurality of pixels, and
wherein each of the plurality of pixels corresponds to a connecting element of the red LED, the green LED, the blue LED, and one from among the plurality of connecting elements.

4. The display module of claim 3, wherein each of the plurality of individual electrodes is an anode,
wherein each of the plurality of common electrodes is a cathode,
wherein each of the plurality of LEDs comprises a plurality of second pixel electrodes, and
wherein the plurality of second pixel electrodes is arranged at different regions of a light emitting surface of each of the plurality of LEDs, respectively.

5. The display module of claim 4, wherein the plurality of semiconductor layers comprises an n-type semiconductor layer, a p-type semiconductor layer, and a light emitting layer between the n-type semiconductor layer and the p-type semiconductor layer,
wherein the p-type semiconductor layer is connected to the first pixel electrode,
wherein the n-type semiconductor layer is connected to the second pixel electrode, and
wherein the plurality of LEDs further comprises a reflection layer surrounding the light emitting layer.

6. The display module of claim 3, wherein each of the plurality of individual electrodes is a cathode,
wherein each of the plurality of common electrodes is an anode,
wherein the second pixel electrode of the red LED comprises a metal, and
wherein the second pixel electrode of each of the green LED and the blue LED comprises indium tin oxide (ITO).

7. The display module of claim 6, wherein the plurality of semiconductor layers comprises an n-type semiconductor layer, a p-type semiconductor layer, and a light emitting layer between the n-type semiconductor layer and the p-type semiconductor layer,
wherein the p-type semiconductor layer is connected to the second pixel electrode,
wherein the n-type semiconductor layer is connected to the first pixel electrode, and
wherein the plurality of LEDs further comprises an insulation layer surrounding the light emitting layer.

8. The display module of claim 1, wherein the display module further comprises a bottom contact layer on the circuit board, and
wherein the bottom contact layer comprises a plurality of conductive balls connecting the plurality of individual electrodes to the first pixel electrode and connecting the plurality of common electrodes to the plurality of connecting elements.

9. The display module of claim 1, wherein the top connection layer is at least one of a first top connection layer which comprises indium tin oxide (ITO), and a second top connection layer which comprises a transparent anisotropic conductive film (ACF) and a glass substrate.

10. The display module of claim 1, wherein the plurality of connecting elements comprises at least one of a first connecting element, a second connecting element comprising a metal, and a third connecting element comprising a metal coated polymer, and
wherein the first connecting element comprises a semiconductor layer, an upper electrode at an upper portion of the semiconductor layer and connected to the top connection layer, and a lower electrode at a lower portion of the semiconductor layer and connected to a common electrode.

11. An electronic device comprising a display module, the display module comprising:
a circuit board which comprises a plurality of individual electrodes and a plurality of common electrodes having a polarity opposite to a polarity of the plurality of individual electrodes;
a plurality of light emitting diodes (LEDs), each LED of the plurality of LEDS comprising a plurality of semiconductor layers, a first pixel electrode connected to the plurality of individual electrodes, and a second pixel electrode at an opposite direction from the first pixel electrode, respectively;
a top connection layer on the plurality of LEDs and connected to the second pixel electrode; and
a plurality of connecting elements connecting the top connection layer to the common electrode.

12. The electronic device of claim 11, wherein the plurality of LEDs comprises a red LED, a green LED, and a blue LED,
wherein each of the plurality of individual electrodes is configured to drive one from among the red LED, the green LED, and the blue LED, and
wherein the plurality of common electrodes is configured to drive the red LED, the green LED, and the blue LED.

13. The electronic device of claim 12, wherein the display module is divided into a plurality of pixels, and
wherein each of the plurality of pixels corresponds to a connecting element of the red LED, the green LED, the blue LED, and one from among the plurality of connecting elements.

14. The electronic device of claim 13, wherein each of the plurality of individual electrodes is an anode,
wherein each of the plurality of common electrodes is a cathode,
wherein each of the plurality of LEDs comprises a plurality of second pixel electrodes, and
wherein the plurality of second pixel electrodes is arranged at different regions of a light emitting surface of each of the plurality of LEDs, respectively.

15. The electronic device of claim 14, wherein the plurality of semiconductor layers comprises an n-type semiconductor layer, a p-type semiconductor layer, and a light emitting layer between the n-type semiconductor layer and the p-type semiconductor layer,
wherein the p-type semiconductor layer is connected to the first pixel electrode,
wherein the n-type semiconductor layer is connected to the second pixel electrode, and
wherein the plurality of LEDs further comprises a reflection layer surrounding the light emitting layer.
